# EUROPÄISCHE PATENTANMELDUNG

(11) **EP 0 698 907 A2**
(43) Veröffentlichungstag der Anmeldung: **28.02.1996**
(21) Anmeldenummer: 95111043.6
(22) Anmeldetag: 14.07.1995
(51) Int. Cl.: H01J 37/065

(54) **Elektronenkanone.**

(30) Priorität: 20.07.1994 UA 94076317
(71) Anmelder: Mishnarodnij Zentr Elektronno-Promenewich Technologij IES im. E.O.Patona NAN Ukraini, Kiew 252005 (UA)
(72) Erfinder: Movchan, Boris A., Kiew 252004 (UA); Timashov, Viktor A., Kiew 25049 (UA); Pijuk, Evgenii L., Kiew 252126 (UA)
(74) Vertreter: Sparing - Röhl - Henseler Patentanwälte

(57) **Zusammenfassung**

Die Erfindung betrifft eine Elektronenkanone mit einer linienförmigen Glühkathode (11) in einem Kathodenblock, der über Hochspannungsisolatoren (3) mit Abstand zu einer Beschleunigungsanode (1) angeordnet ist und einen Rahmen (2) aufweist, der zwei Kathodenhalter (8, 17) aufnimmt, von denen einer (8) über eine stromführende, die Glühkathode (11) spannende Blattfederanordnung (7) und einen Isolator (4) am Rahmen (2) gehalten ist, wobei eine die Glühkathode (11) übergreifende und achsparallel zu dieser angeordnete Fokussierelektrode (20) vorgesehen ist. Hierbei sind die mit einer Klemme zum Anlegen eines Fokussierpotentials verbundene Fokussierelektrode (20) über eine erste starre stromleitende Platte (21) und den Isolator (4) und der zweite Kathodenhalter (17) über eine zweite starre stromleitende Platte (16) am Rahmen (2) befestigt, wobei die Glühkathode (11) in der Vertikalebene durch die Längsachse der Fokussierelektrode (20) durch Verstellung der Blattfederanordnung (7) und der zweiten Platte (16) im Relativabstand gegenüber der Beschleunigungsanode (1) und der Fokussierelektrode (20) einstellbar ist.

## Beschreibung

Die Erfindung betrifft eine Elektronenkanone mit einer linienförmigen Glühkathode in einem Kathodenblock, der über Hochspannungsisolatoren mit Abstand zu einer Beschleunigungsanode angeordnet ist und einen Rahmen aufweist, der zwei Kathodenhalter aufnimmt, von denen einer über eine stromführende, die Glühkathode spannende Blattfederanordnung und einen Isolator am Rahmen gehalten ist, wobei eine die Glühkathode übergreifende und achsparallel zu dieser angeordnete Fokussierelektrode vorgesehen ist.

Elektronenkanonen dienen dazu, einen Elektronenstrahl zu erzeugen, der beispielsweise zur Elektronenstrahlerwärmung bzw. zum Schmelzen oder Verdampfen von Werkstoffen im Vakuum verwendet werden kann.

Eine derartige Elektronenkanone ist aus der US-A-4 126 811 bekannt, bei der eine linienförmige Glühkathode, an jedem Ende von einem Kathodenhalter gehalten, durch zwei Blattfederanordnungen gespannt wird, die jeweils zwischen einer Stromzuführungsklemme und einer Fokussierelektrodenhälfte angeordnet sind, wobei jede der getrennt und mit geringem Abstand zueinander angeordneten Fokussierelektrodenhälften einen der Kathodenhalter trägt. Die Fokussierelektrodenhälften sind somit nicht von der Glühkathode elektrisch getrennt, so daß ein von der Glühkathode erzeugter Elektronenstrahl keinem veränderlichen Fokussierpotential ausgesetzt werden kann, so daß sich die Formierung des Elektronenstrahls und die optischen Kenngrößen des Fokalflecks nicht beeinflussen lassen. Bei länger andauerndem Betrieb einer Elektronenkanone verändern sich aber die elektronenoptischen Kennwerte wie Konvergenz des Elektronenstrahls und des Fokalflecks auf der zu erwärmenden Fläche sowie der spezifischen Leistung des Elektronenstrahls. Außerdem wird hierbei keine optimale, stabile Position der Glühkathode zur Fokussierelektrode gewährleistet, vielmehr kann sich die Position der Glühkathode gegenüber der Fokussierelektrode verändern, zumal sich außer der Glühkathode weitere Bauteile der Elektronenkanone erwärmen. Die Stabilität des mit dem Elektronenstrahl durchzuführenden Prozesses wird daher nicht gewährleistet.

Ferner ist aus der US-A-3 701 915 eine Elektronenkanone bekannt, bei der die Glühkathode zwischen zwei, an einem Bügel elektrisch isoliert befestigten, stromführenden Blattfedern eingespannt ist, während die Fokussierelektrode ebenfalls von dem Bügel elektrisch isoliert von den Blattfedern und der Glühkathode getragen wird. Auch hierbei besteht das Problem, daß sich die Blattfedern beim Betrieb der Elektronenkanone durch Erwärmung verlängern und dadurch die Position der Glühkathode zur Fokussierelektrode verändert.

Aufgabe der Erfindung ist es, eine Elektronenkanone der eingangs genannten Art zu schaffen, bei der bei einfacher Konstruktion eine Beeinflussung des Elektronenstrahls mit unterschiedlichem Fokussierpotential sowie eine Verstellung der Glühkathode zur Fokussierelektrode ermöglicht wird.

Diese Aufgabe wird dadurch gelöst, daß die mit einer Klemme zum Anlegen eines Fokussierpotentials verbundene Fokussierelektrode über eine erste starre stromleitende Platte und den Isolator und der zweite Kathodenhalter über eine zweite starre stromleitende Platte am Rahmen befestigt sind, wobei die Glühkathode in der Vertikalebene durch die Längsachse der Fokussierelektrode durch Verstellung der Blattfederanordnung und der Zweiten Platte im Relativabstand gegenüber der Beschleunigungsanode und der Fokussierelektrode einstellbar ist.

Hierdurch wird bewirkt, daß die Fokussierelektrode elektrisch von der Glühkathode getrennt ist, so daß erstere mit einem gewünschten negativen Fokussierpotential in bezug auf die Glühkathode beaufschlagbar ist, die Glühkathode nur mittels einer Blattfederanordnung gespannt ist, wodurch die Konstruktion vereinfacht wird, und ferner in ihrer Position in bezug auf die Fokussierelektrode einstellbar ist. Hierdurch läßt sich die Stabilität der elektronenoptischen Kenngrößen erhöhen ebenso wie die Reproduzierbarkeit von Prozeßkenngrößen beim Schmelzen und Verdampfen von Werkstoffen im Vakuum gewährleisten. Insbesondere läßt sich eine für den jeweils durchzuführenden Prozeß optimale Einstellung der Position der Glühkathode zur Fokussierelektrode vornehmen, wobei eine Feinabstimmung entsprechend den im Betrieb auftretenden Veränderungen durch Änderung des Fokussierpotentials vorgenommen wird.

Weitere Ausgestaltungen der Erfindung sind der nachfolgenden Beschreibung und den Unteransprüchen zu entnehmen.

Die Erfindung wird nachstehend anhand eines in den beigefügten Abbildungen dargestellten Ausführungsbeispiels näher erläutert.

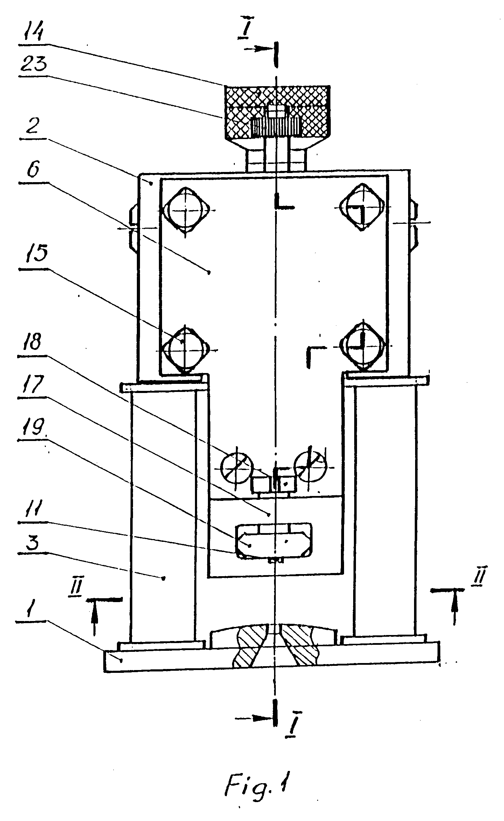

Fig. 1 zeigt eine Seitenansicht einer Elektronenkanone teilweise im Schnitt.

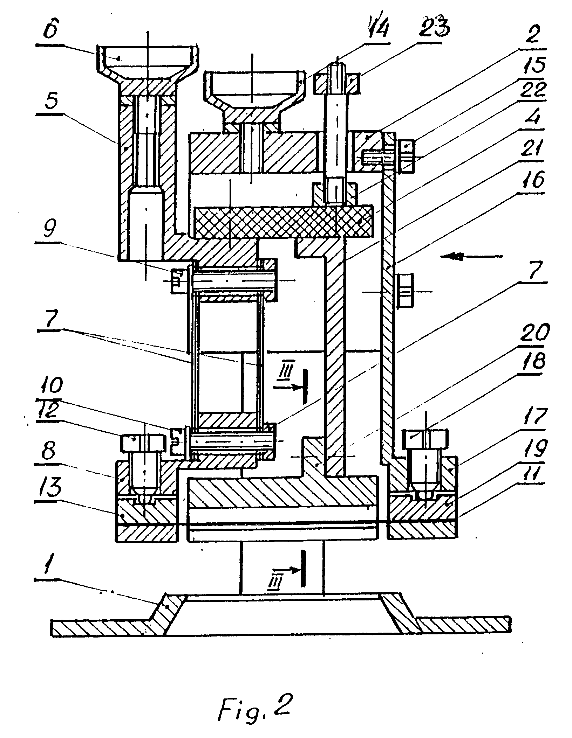

Fig. 2 zeigt einen Schnitt längs der Linie I-I von Fig. 1.

Fig. 3 zeigt einen Schnitt längs der Linie II-II von Fig. 1.

Fig. 4 zeigt einen Schnitt längs der Linie III-III von Fig. 2.

Die dargestellte Elektronenkanone umfaßt eine Beschleunigungsanode 1 und einen Kathodenblock mit einem Rahmen 2, der von Hochspannungsisolatoren 3 mit Abstand zur Beschleunigungsanode 1 getragen wird. Der Kathodenblock umfaßt ferner einen flachen, plattenförmigen, etwa parallel zur Beschleunigungsanode 1 verlaufenden Isolator 4, an dem eine Stromzuführung 5 mit einer Klemme 6 befestigt ist. Mit der Stromzuführung 5 sind die einen Enden von stromführenden Blattfedern 7 verbunden, während deren andere Enden mit einem Kathodenhalter 8 benachbart zur Beschleunigungsanode 1 verbunden sind. Die Blattfedern 7 sind mit der Stromzuführung 5 und dem Kathodenhalter 8 über Befestigungsmittel 9, 10 etwa in Form von Schrauben verbunden und in zwei zueinander beabstandeten Gruppen angeordnet. Der Kathodenblock umfaßt eine linienförmige Glühkathode 11, die an einem Ende von dem Kathodenhalter 8 gehalten wird, und zwar mittels einer Schraube 12 und eine Spannplatte 13.

Eine zweite Klemme 14 ist unmittelbar am Rahmen 2 des Kathodenblocks angeordnet, wobei mittels Schrauben 15 am Rahmen 2 ferner eine starre, stromführende Platte 16 befestigt ist, die einen weiteren Kathodenhalter 17 trägt, der das andere Ende der Glühkathode 11 hält, und zwar mittels einer Schraube 18 und einer Spannplatte 19.

Die Löcher für die Schrauben 9, 10, 15 in den Blattfedern 7 und der Platte 16 sind hierbei mit solchen Toleranzen versehen, daß eine Einstellung der Lage des Kathodenhalters 8 mit der an dieser befestigten Glühkathode 11 in bezug auf eine Fokussierelektrode 20 ermöglicht wird, die zwischen den Kathodenhaltern 8, 17 angeordnet und über eine starre Platte 21 und unter Zuhilfenahme einer Leiste 22 am Isolator 4 befestigt ist. Die Leiste 22 ist mit einer Klemme 23 für das Fokussierpotential der Fokussierelektrode 20 verbunden, wobei die Klemme 23 durch eine Öffnung des Rahmens 2 ohne elektrischen Kontakt zu letzterem nach außen geführt ist, so daß die Fokussierelektrode 20 von der Glühkathode 11 elektrisch isoliert ist.

Wenn die Klemmen 6 und 14 mit einer Stromquelle verbunden werden, fließt ein Heizstrom zwischen den Klemmen 6 und 14 über die Stromzuführung 5, die Blattfedern 7, den Kathodenhalter 8, die Glühkathode 11, den Kathodenhalter 17, die Platte 16 und den Rahmen 2. Der Heizstrom erwärmt die Glühkathode 11 auf ihre Betriebstemperatur, die allgemein in der Größenordnung von 2200 bis 2300°C liegt. Unter dieser Erwärmung erfolgt eine lineare Ausdehnung der Glühkathode 11. Damit die Geometrie des elektronenoptischen Systems nicht durch eine Durchbiegung der Glühkathode 11 gestört wird, muß letztere ständig gespannt bleiben, was mittels der Blattfedern 7 geschieht, die die Glühkathode entsprechend vorspannen.

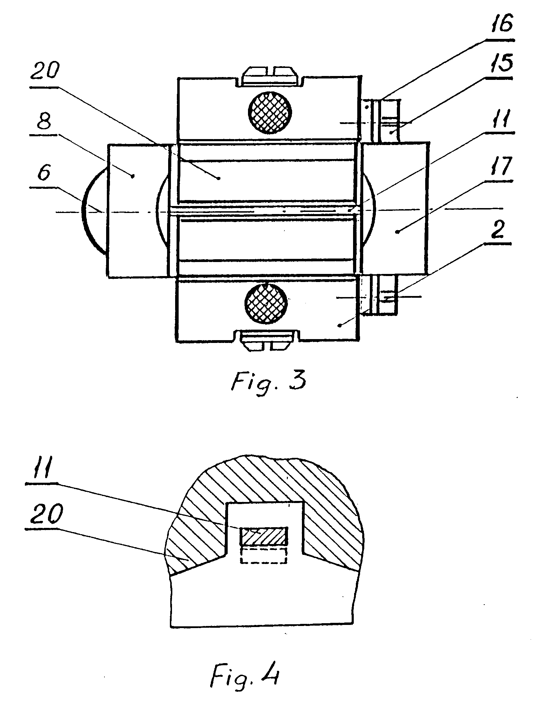

Die Position der linienförmigen Glühkathode 11 in bezug auf die benachbarten Kathodenflächen der Fokussierelektrode 20 (Fig. 4), die zum optimalen Betrieb nötig ist, wird durch Einstellen der Lage des Kathodenhalters 8 mittels der Schrauben 9, 10 und des Kathodenhalters 17 mittels der Schrauben 15 justiert.

Zwei mögliche Positionen der Glühkathode 11 zur Fokussierelektrode 20 sind in Fig. 4 ausgezogen bzw. gestrichelt dargestellt.

Zur Nachfokussierung des Elektronenstrahls und zum Korrigieren der elektronenoptischen Kenngrößen, die von der Dehnung der erwärmten Teile des Kathodenblocks und der Glühkathode 11 selbst beeinflußt werden, wird die Fokussierelektrode 20 über die Klemme 23 mit einem in bezug auf die Glühkathode 11 negativen Potential beaufschlagt. Durch die Änderung der Größe dieses Potentials läßt sich die Größe des Fokusabstandes des Elektronenstrahls und damit die Größe des Fokalflecks ändern.

Die Löcher für die Schrauben 9, 10, 15 können als Langlöcher ausgebildet sein. Der Abstand zwischen der Glühkathode 11 und der Fokussierelektrode 20 kann auch über Verstellmittel regulierbar sein.

Die Glühkathode 11 kann auch durch zwei parallele, linienförmige Einzelkathoden gebildet werden.

## Patentansprüche

1. Elektronenkanone mit einer linienförmigen Glühkathode (11) in einem Kathodenblock, der über Hochspannungsisolatoren (3) mit Abstand zu einer Beschleunigungsanode (1) angeordnet ist und einen Rahmen (2) aufweist, der zwei Kathodenhalter (8, 17) aufnimmt, von denen einer (8) über eine stromführende, die Glühkathode (11) spannende Blattfederanordnung (7) und einen Isolator (4) am Rahmen (2) gehalten ist, wobei eine die Glühkathode (11) übergreifende und achsparallel zu dieser angeordnete Fokussierelektrode (20) vorgesehen ist, dadurch **gekennzeichnet**, daß die mit einer Klemme zum Anlegen eines Fokussierpotentials verbundene Fokussierelektrode (20) über eine erste starre stromleitende Platte (21) und den Isolator (4) und der zweite Kathodenhalter (17) über eine zweite starre stromleitende Platte (16) am Rahmen (2) befestigt sind, wobei die Glühkathode (11) in der Vertikalebene durch die Längsachse der Fokussierelektrode (20) durch Verstellung der Blattfederanordnung (7) und der zweiten Platte (16) im Relativabstand gegenüber der Beschleunigungsanode (1) und der Fokussierelektrode (20) einstellbar ist.

2. Elektronenkanone nach Anspruch 1, dadurch gekennzeichnet, daß die Blattfederanordnung (7) und die zweite Platte (16) Löcher für Befestigungselemente (9, 10, 15) aufweisen, die Spiel zum Verstellen der Blattfederanordnung (7) und der zweiten Platte (16) aufweisen.

3. Elektronenkanone nach Anspruch 1 oder 2, dadurch gekennzeichnet, daß die Löcher als Langlöcher ausgebildet sind.

4. Elektronenkanone nach einem der Ansprüche 1 bis 3, dadurch gekennzeichnet, daß der Abstand zwischen der Glühkathode (11) und der Fokussierelektrode (20) regulierbar ist.

5. Elektronenkanone nach einem der Ansprüche 1 bis 4, dadurch gekennzeichnet, daß der Isolator (4) als flache Platte ausgebildet ist.
